# FASCICULE DE BREVET EUROPEEN

(11) **EP 3 134 751 B1**
(45) Date de publication et mention de la délivrance du brevet: **18.07.2018**
(21) Numéro de dépôt: 15716836.0
(22) Date de dépôt: 21.04.2015
(51) Int. Cl.: G01T 7/00

(54) **DISPOSITIF ET PROCÉDÉ SIMULANT LA DÉTECTION DE SOURCES RADIOACTIVES MOBILES**
VORRICHTUNG UND VERFAHREN ZUR SIMULATION DER DETEKTION VON BEWEGLICHEN RADIOAKTIVEN QUELLEN
DEVICE AND METHOD SIMULATING THE DETECTION OF MOVING RADIOACTIVE SOURCES

(30) Priorité: 23.04.2014 FR 1453645
(43) Date de publication de la demande: 01.03.2017
(73) Titulaire: Commissariat à l'Énergie Atomique et aux Énergies Alternatives, 75015 Paris (FR)
(72) Inventeur: THEVENIN, Mathieu, F-91400 Saclay (FR); BOUDERGUI, Karim, F-28630 Nogent-le-Phaye (FR)
(74) Mandataire: Brevalex
(86) Numéro de dépôt international: PCT/EP2015/058558
(87) Numéro de publication internationale: WO 2015/162111

(56) Documents cités:
- US-A- 3 363 329
- US-A- 3 636 641
- US-A- 6 033 225
- US-A1- 2009 263 771

## Description

### DOMAINE TECHNIQUE

Le domaine de l'invention est celui de l'instrumentation nucléaire, et plus particulièrement celui du test, de l'étalonnage et de la maintenance de dispositifs de détection de sources radioactives. Dans ce contexte, l'invention vise un système simulant la détection de sources radioactives mobiles à des fins notamment de test d'instrumentations nucléaires.

### ÉTAT DE LA TECHNIQUE ANTÉRIEURE

Le test d'instrumentations nucléaires en conditions réelles ou réalistes nécessite d'avoir recours à des sources radioactives. Si cela est parfois envisageable en laboratoire, l'usage de certains radioéléments est prohibé et réglementé (polonium, mercure, etc.), ou dangereux (plutonium). Et même si des essais en laboratoire peuvent être réalisés, ce n'est pas le cas d'essais en milieux ouverts ou publics (ports, aéroports, etc.) pourtant nécessaires afin de valider les développements ou de tester le fonctionnement de certains instruments, comme des portiques de détection ou des spectromètres par exemple.

Pour contourner cette difficulté dans le domaine de la formation des personnels de radioprotection, des solutions existantes à ce jour proposent d'utiliser un dispositif émetteur radio mobile auquel est associé un récepteur radio (voir par exemple le document US 3,636,641), ou encore d'avoir recours à un émetteur mobile à ultra-son et à un capteur associé, ce qui permet de faire aisément varier la distance et d'illustrer l'effet de blindages. Ces dispositifs, utilisés pour la formation, ne sont toutefois en mesure que d'indiquer un taux de radiation équivalent estimé sans prendre en compte la nature du radio-émetteur. Ils ne peuvent par ailleurs être connectés à aucun système de mesure ou de traitement du signal, comme un spectromètre par exemple, et ne peuvent donc permettre de tester un système complet de détection de sources radioactives.

D'autres approches permettent de s'affranchir de cette dernière problématique en venant connecter sur un système complet un générateur de signaux à la place des détecteurs. Un tel générateur peut notamment permettre de simuler une grande variété de sources radioactives. Toutefois, ces approches ne permettent pas de simuler une source distante, et notamment une source mobile, puisque qu'elles nécessitent la connexion du générateur de signaux à la place du détecteur et génèrent un signal dont les caractéristiques ont été programmées.

En outre, ces solutions sont limitées à un seul détecteur et ne peuvent être utilisées pour tester des systèmes disposant d'un grand nombre de détecteurs.

### EXPOSÉ DE L'INVENTION

L'invention a pour objectif de permettre de réaliser des essais extérieurs, hors laboratoire, d'instrumentations nucléaires, tout en s'affranchissant de l'utilisation de source radioactive, quel que soit l'instrument à tester, y compris des spectromètres. Plus particulièrement, elle vise à intégrer dans un système de détection de source radioactive complet un système permettant de simuler une source radioactive mobile, ce qui est aujourd'hui inexistant.

A cet effet, l'invention propose un système simulant la détection d'au moins une source radioactive mobile tel que défini par la revendication 1.

Certains aspects préférés mais non limitatifs de ce système sont définis dans les revendications 2 à 10.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- la figure 1 est un schéma représentant un mode de réalisation possible du système selon l'invention ;
- la figure 2 représente la génération aléatoire au cours du temps d'un nombre d'impulsions fonction de la distance détectée séparant le récepteur ;
- les figures 3 et 4 illustrent deux variantes de réalisation possibles du générateur d'impulsions du système selon l'invention ;
- la figure 5 représente un spectre en énergie d'une source radioactive sous la forme de probabilité d'apparition des impulsions en fonction de leur amplitude.

### EXPOSÉ DÉTAILLÉ DE MODES DE RÉALISATION PARTICULIERS

L'invention porte sur un système simulant la détection d'au moins une source radioactive mobile, ce système intégrant un dispositif permettant de tester une électronique de traitement T qui est couplée, en utilisation nominale de détection, à un ou plusieurs détecteurs d'une ou plusieurs sources radioactives.

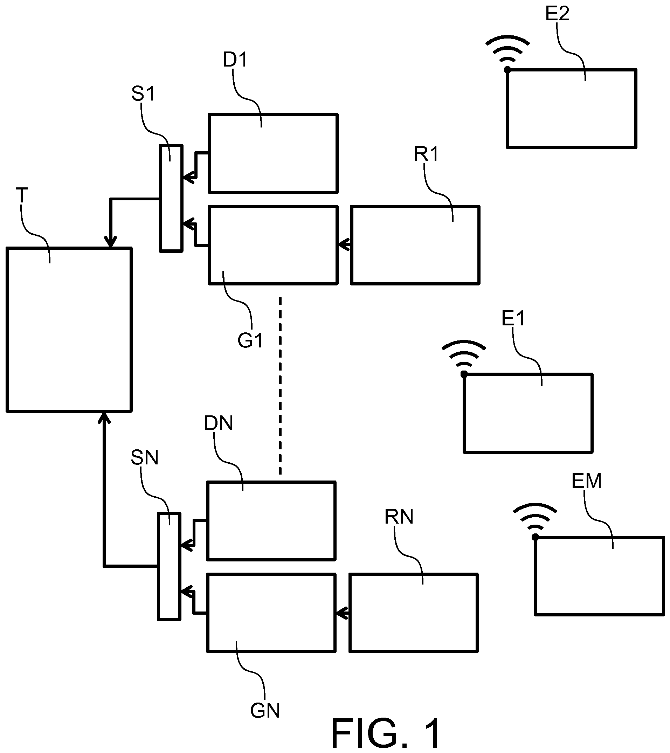

En référence à la figure 1, le dispositif comprend au moins un récepteur R1, RN de signaux émis par au moins un émetteur E1, E2, EM de signaux, chacun des émetteurs étant localisé et éventuellement déplacé pour simuler une ou plusieurs sources radioactives, notamment des sources mobiles.

Les signaux sont de préférence des signaux sans fil, par exemple des signaux RF (wifi, Bluetooth®, etc.), ultrasonores ou lumineux. Une technologie filaire peut néanmoins être exploitée, au détriment certes de la flexibilité du dispositif objet de l'invention.

Le dispositif comporte par ailleurs au moins un générateur d'impulsions G1, GN couplé, d'une part, à un récepteur R1, RN, et destiné à être couplé, d'autre part, à l'électronique de traitement T à tester.

Un générateur d'impulsions G1, GN est plus précisément configuré pour déterminer une distance entre le récepteur R1, RN auquel il est couplé et l'un des émetteurs de signaux E1, E2, EM à partir d'un signal reçu de l'émetteur par le récepteur. Le générateur d'impulsions G1, GN vient ainsi déterminer une distance vers chacun des émetteurs E1, E2, EM lorsque plusieurs émetteurs sont prévus.

Un générateur d'impulsions G1, GN est par ailleurs configuré pour générer des impulsions dont le nombre varie en fonction de la ou des distances détectées.

Le signal généré par un générateur d'impulsions G1, GN présente les mêmes caractéristiques électriques que le signal généré par un détecteur D1, DN d'une ou plusieurs sources radioactives. Dans un mode de réalisation possible, le ou les générateurs d'impulsions G1, GN sont configurables de manière à générer des signaux correspondant à différents types de détecteur (scintillateur, semi-conducteur, etc.).

Dans un mode de réalisation possible, le dispositif comprend au moins un module de sélection S1, SN configuré pour permettre de coupler sélectivement l'électronique de traitement T à un détecteur D1, DN d'une ou plusieurs sources radioactives en utilisation nominale de détection, ou à un générateur d'impulsions G1, GN en phase de test de l'électronique de traitement.

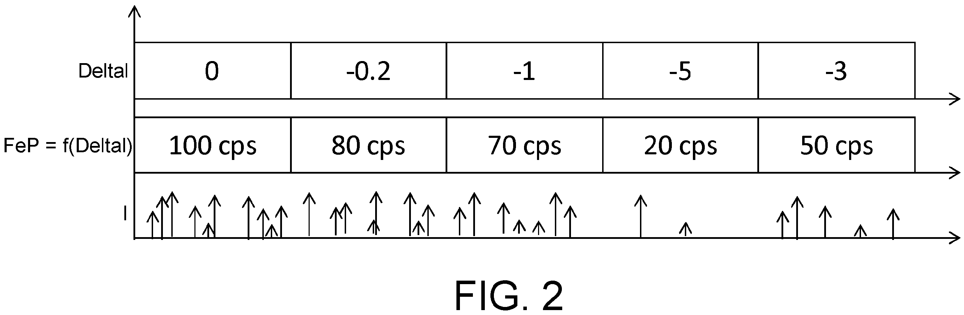

En référence à la figure 2, le générateur d'impulsions peut être configuré pour périodiquement déterminer un nombre d'impulsions à générer en fonction de la ou des distances déterminées Deltal, et pour générer aléatoirement ledit nombre d'impulsions déterminé pendant la période suivant ladite détermination.

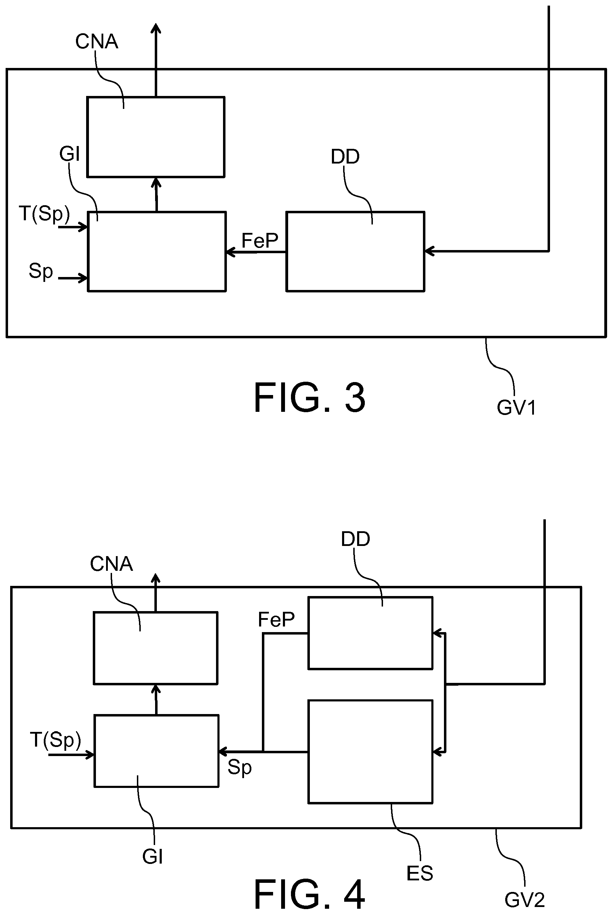

En référence aux figures 3 et 4 illustrant deux variantes de réalisation du générateur d'impulsions GV1, GV2, ce dernier comporte un module DD configuré pour déterminer la distance séparant le récepteur auquel il est couplé d'un émetteur, par exemple à partir d'une mesure de l'amplitude du signal reçu par le récepteur, et pour déterminer le nombre d'impulsions à générer.

D'une manière générale, si la source radioactive simulée par un émetteur s'éloigne, la fréquence d'émission des impulsions FeP diminue. De même, si la source radioactive simulée se rapproche, alors la fréquence des émissions FeP augmente. La fréquence d'émission peut notamment diminuer selon le carré de la distance.

La détermination de la distance est réalisée régulièrement, de sorte que la fréquence d'émission FeP est remise à jour régulièrement comme illustré par la Figure 3. Afin de simuler la réalité physique, un mode de réalisation privilégié fait générer les impulsions à des instants aléatoires, par exemple suivant une loi de Poisson, au cours de la période de validité de la distance déterminée afin que la fréquence de génération tende vers FeP.

Bien entendu, en présence de plusieurs émetteurs, plusieurs distances sont déterminées, un nombre d'impulsions à générer est déterminé, notamment à partir de chacune des distances déterminées, et le générateur d'impulsions génère un nombre total d'impulsions correspondant à la somme des nombres d'impulsions déterminés chacun à partir d'une distance à un émetteur.

La détermination de la distance séparant un récepteur d'un émetteur peut se baser sur la mesure de l'atténuation du signal émis par un émetteur et reçu par un récepteur afin de déterminer l'évolution de la distance relative entre l'émetteur et le récepteur. Une calibration (qui peut être faite en laboratoire) permet de passer de distance relative à absolue. Sur la figure 2, la référence 100 correspond à la référence de la première mesure, et Deltal correspond à l'évolution de la distance relative par rapport à la première mesure, sachant que l'intensité du signal évolue au carré de la vitesse.

Un dispositif de localisation, tel qu'un GPS, placé au niveau d'un émetteur, et optionnellement au niveau d'un récepteur, permet d'affiner la mesure de distance.

La mesure de l'amplitude du signal émis peut varier aussi en fonction de l'environnement (et pas seulement de la distance) et notamment à cause de l'effet écran (un mur de béton va induire une forte réduction de l'amplitude du signal émis sans pour autant être causé par une grande distance). Ce phénomène, qui est le même que pour les rayonnements ionisants, est avantageusement pris en compte par l'invention qui permet de faire varier le taux de comptage en fonction de la présence ou non d'un tel effet écran de la même manière que pour la distance. Dans une implémentation, un dispositif de localisation peut avantageusement être exploité pour affiner la génération des impulsions. En effet, si un signal atténué est reçu alors que la distance est proche, il est possible d'en déduire la présence d'un écran. Or, un écran agit comme un filtre passe-bande (généralement passe-haut) sur le spectre du signal. Il est ainsi possible d'utiliser automatiquement un tel filtre lorsqu'un écran est détecté afin de générer un spectre « dégradé » souhaité par la présence d'un écran, et ce à partir du spectre initialement souhaité. Cela permet d'augmenter le réalisme de la simulation. Enfin la nature de l'écran peut être prise en compte afin de sélectionner le filtre passe-bande ad-hoc. Cela est possible par des techniques de modélisation de l'environnement, de réalité augmentée, etc.

Un générateur d'impulsions est par ailleurs configuré pour générer des impulsions dont la forme et l'intensité sont caractéristiques de la ou des sources radioactives simulées.

La forme des impulsions à générer comprend typiquement les caractéristiques suivantes : une amplitude, un temps de montée et un temps de descente, une forme de la descente (typiquement plus ou moins bombée). Cette forme est donnée par les caractéristiques du détecteur à simuler, et peut être influencée par l'éventuelle présence d'un écran sur le trajet émetteur-récepteur. Ces caractéristiques sont fournies au générateur d'impulsions, et sont de préférence paramétrables.

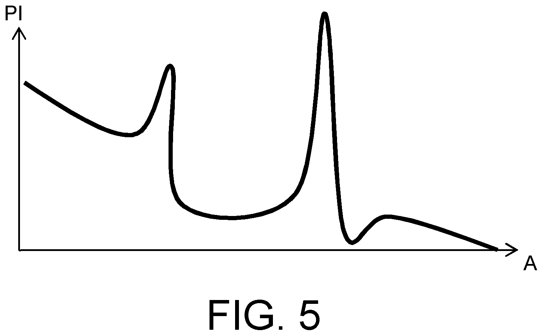

L'intensité des impulsions peut être déterminée par le générateur d'impulsions à partir d'un spectre en énergie Sp prédéfini, correspondant à un ou plusieurs radioéléments et représentant par exemple une probabilité d'apparition des impulsions PI en fonction de l'amplitude A comme représenté sur l'exemple de la figure 5.

Le générateur d'impulsions peut être configuré pour modifier le spectre en énergie en fonction de caractéristiques d'un détecteur à simuler. Une transformation T(Sp) peut ainsi être appliquée au spectre Sp, cette transformation correspondant à la fonction de transfert du détecteur simulé.

Le spectre en énergie Sp peut être fourni directement à un module d'émission d'impulsions GI du générateur d'impulsions GV1, comme représenté sur la figure 3. Ce spectre Sp peut être choisi par l'utilisateur, par exemple en étant sélectionné dans une base de données.

Dans une variante représentée sur la figure 4, le générateur d'impulsions GV2 comprend un module d'extraction ES configuré pour extraire le spectre en énergie Sp du signal reçu de l'émetteur par le récepteur. Le signal émis par l'émetteur est par exemple modulé pour porter cette information.

L'émetteur peut par ailleurs émettre les caractéristiques de chaque impulsion à générer, associées ou non à l'identification d'un ou plusieurs générateurs d'impulsions afin que ces derniers puissent savoir quelles impulsions générer. Dans un tel cas de figure, le générateur d'impulsions vient sélectionner aléatoirement les impulsions à générer parmi celles envoyées par l'émetteur en respectant le critère du nombre d'impulsions à générer en fonction de la distance détectée.

Comme représenté sur les figures 3 et 4, le générateur d'impulsions GV1, GV2 peut par ailleurs comporter un module CNA de conversion numérique-analogique, agencé en sortie du module d'émission d'impulsions GI et permettant de fournir à l'électronique de traitement T des impulsions analogiques.

Chaque générateur d'impulsions peut par ailleurs être configurable. Les éléments de configuration comprennent par exemple le spectre du ou des radioéléments à simuler, le taux de comptage à simuler, ou encore le type de détecteur à simuler ce qui a un impact sur la forme des impulsions générées. Les éléments de configuration peuvent notamment être communiqués par l'intermédiaire des signaux transmis par l'émetteur.

On aura compris que l'invention propose un système mobile permettant de simuler une ou plusieurs sources radioactives fixes ou mobiles et de les détecter. Un ou plusieurs émetteurs, par exemple radiofréquence, permettent de simuler la ou les sources. Un ou plusieurs récepteurs permettent de recevoir le ou les signaux du ou des émetteurs et d'en déduire une ou plusieurs distances, par exemple en fonction de l'intensité des signaux RF, correspondant à la détection de la ou des sources simulées. Un signal répondant aux caractéristiques d'un ou plusieurs radionucléides est alors généré en fonction des caractéristiques du signal émis par l'émetteur par un générateur d'impulsions qui vient remplacer les détecteurs habituellement utilisés (chambre à fission, scintillateurs plastiques, Nal etc.) dans le cadre des applications d'instrumentation nucléaires.

L'invention n'est pas limitée au système tel que précédemment décrit, mais s'étend également à un procédé de simulation de détection d'au moins une source radioactive mobile à l'aide du dispositif précédemment décrit, et notamment à un procédé comprenant l'émission et la réception de signaux par un émetteur et un récepteur de signaux, respectivement, caractérisé en ce qu'il comporte les étapes mises en oeuvre par un générateur d'impulsions couplé, d'une part, au récepteur, et, d'autre part, à une électronique de traitement à tester destinée à être couplée, en utilisation nominale de détection, à un ou plusieurs détecteurs d'une ou plusieurs sources radioactives, consistant à :
- déterminer une distance entre le récepteur et l'émetteur à partir d'un signal reçu de l'émetteur par le récepteur ;
- générer des impulsions dont le nombre varie en fonction de la distance détectée ;
- et délivrer les impulsions générées à l'électronique de traitement T à tester.

Enfin, l'invention s'étend également à un produit programme d'ordinateur, comprenant des instructions de code pour l'exécution des étapes de ce procédé mises en oeuvre par le générateur d'impulsions, lorsque ledit programme est exécuté sur un ordinateur.

## Revendications

1. Système simulant la détection d'au moins une source radioactive mobile, comprenant au moins un émetteur (E1, E2, EM) de signaux, un dispositif simulant la détection d'au moins une source radioactive mobile, et une électronique de traitement (T) à tester destinée à être couplée, en utilisation nominale de détection, à un ou plusieurs détecteurs (D1, DN) d'une ou plusieurs sources radioactives, ledit dispositif comprenant :
- un récepteur (R1, RN) de signaux émis par l'au moins un émetteur (E1, E2, EM) ; et
- un générateur d'impulsions (G1, GN, GV1, GV2) couplé au récepteur (R1, RN) et configuré pour déterminer une distance (Deltal) entre le récepteur (R1, RN) et l'au moins un émetteur (E1, E2, EM) à partir d'un signal reçu de l'au moins un émetteur par le récepteur, pour générer des impulsions dont le nombre (FeP) varie en fonction de la distance détectée et pour délivrer les impulsions générées à l'électronique de traitement (T) à tester.

2. Système selon la revendication 1, dans lequel le générateur d'impulsions est configuré pour périodiquement déterminer un nombre d'impulsions à générer en fonction de la distance déterminée, et pour générer aléatoirement ledit nombre d'impulsions déterminé pendant la période suivant ladite détermination.

3. Système selon l'une des revendications 1 et 2, dans lequel le générateur d'impulsions est en outre configuré pour générer des impulsions dont la forme est caractéristique d'une ou plusieurs sources radioactives.

4. Système selon la revendication 3, dans lequel la forme des impulsions à générer comprend une amplitude, un temps de montée et un temps de descente des impulsions.

5. Système selon la revendication 4, dans lequel l'amplitude des impulsions est déterminée par le générateur d'impulsions à partir d'un spectre en énergie (Sp) représentant une probabilité d'apparition des impulsions en fonction de l'amplitude.

6. Système selon la revendication 5, dans lequel le générateur d'impulsions est configuré pour extraire le spectre en énergie du signal reçu de l'émetteur par le récepteur.

7. Système selon l'une des revendications 5 et 6, dans lequel le générateur d'impulsions est configuré pour modifier le spectre en énergie en fonction de caractéristiques (T(Sp)) d'un détecteur à simuler.

8. Système selon l'une des revendications 1 à 7, dans lequel ledit dispositif comprend une pluralité de générateurs d'impulsions (G1, GN), chacun couplé à un récepteur (R1, RN) de signaux émis par l'au moins un émetteur (E1, E2, EM).

9. Système selon l'une des revendications 1 à 8, comprenant un outre un module de sélection (S1, SN) configuré pour permettre de coupler sélectivement l'électronique de traitement (T) à un détecteur (D1, DN) d'une ou plusieurs sources radioactives en utilisation nominale de détection, ou au générateur d'impulsions (G1, GN) en phase de test de l'électronique de traitement.

10. Système selon la revendication 9, comprenant en outre un ou plusieurs émetteurs mobiles de signaux.

11. Procédé de simulation de détection d'au moins une source radioactive mobile, comprenant l'émission de signaux par au moins un émetteur (E) et la réception de signaux par un récepteur (R1, RN), **caractérisé en ce qu'**il comporte les étapes suivantes mises en oeuvre par un générateur d'impulsions (G1, GN, GV1, GV2) couplé, d'une part, au récepteur (R1, RN), et, d'autre part, à une électronique de traitement (T) à tester destinée à être couplée, en utilisation nominale de détection, à un ou plusieurs détecteurs (D1, DN) d'une ou plusieurs sources radioactives, consistant à :
- déterminer une distance (deltal) entre le récepteur (R1, RN) et l'au moins un émetteur (E) à partir d'un signal reçu de l'au moins un émetteur par le récepteur;
- générer des impulsions dont le nombre (FeP) varie en fonction de la distance détectée ; et
- délivrer les impulsions générées à l'électronique de traitement (T) à tester.

12. Produit programme d'ordinateur, comprenant des instructions de code pour l'exécution des étapes du procédé selon la revendication 11 mises en oeuvre par le générateur d'impulsions (G1, GN, GV1, GV2), lorsque ledit programme est exécuté sur un ordinateur.

## Patentansprüche

1. System, welches die Detektion wenigstens einer mobilen radioaktiven Quelle simuliert, umfassend wenigstens einen Sender (E1, E2, EM) von Signalen, eine Vorrichtung, welche die Detektion wenigstens einer mobilen radioaktiven Quelle simuliert, und eine zu testende Verarbeitungselektronik (T), die dazu bestimmt ist, im nominellen Detektionsbetrieb mit einem oder mehreren Detektoren (D1, DN) für eine oder mehrere radioaktive Quellen verbunden zu sein, wobei die Vorrichtung umfasst:
• einen Empfänger (R1, RN) von Signalen, die durch den wenigstens einen Sender (E1, E2, EM) gesendet werden, und
• einen Pulsgenerator (G1, GN, GV1, GV2), der mit dem Empfänger (R1, RN) gekoppelt und konfiguriert ist, um einen Abstand (Deltal) zwischen dem Empfänger (R1, RN) und dem wenigstens einen Sender (E1, E2, EM) zu bestimmen, ausgehend von einem Signal, das von dem wenigstens einen Sender durch den Empfänger empfangen wird, um Pulse zu erzeugen, deren Anzahl (FeP) als Funktion des detektierten Abstands variiert, und um die erzeugten Pulse zu der zu testenden Verarbeitungselektronik (T) zu liefern.

2. System nach Anspruch 1, wobei der Pulsgenerator dazu konfiguriert ist, periodisch eine Anzahl von zu erzeugenden Pulsen zu bestimmen, als Funktion des bestimmten Abstands, und um in zufälliger Weise die bestimmte Anzahl von Pulsen während der Periode nach der Bestimmung zu erzeugen.

3. System nach einem der Ansprüche 1 und 2, wobei der Pulsgenerator weiterhin dazu konfiguriert ist, Pulse zu erzeugen, deren Form charakteristisch für eine oder mehrere radioaktiven Quellen ist.

4. System nach Anspruch 3, wobei die Form der zu erzeugenden Pulse eine Amplitude, eine Anstiegszeit und eine Abfallzeit der Pulse umfasst.

5. System nach Anspruch 4, wobei die Amplitude der Pulse durch den Pulsgenerator ausgehend von einem Energiespektrum (Sp) bestimmt wird, welches eine Wahrscheinlichkeit des Auftretens von Pulsen als Funktion der Amplitude darstellt.

6. System nach Anspruch 5, wobei der Pulsgenerator dazu konfiguriert ist, das Energiespektrum aus dem von dem Sender durch den Empfänger empfangenen Signal zu extrahieren.

7. System nach einem der Ansprüche 5 und 6, wobei der Pulsgenerator dazu konfiguriert ist, das Energiespektrum als Funktion von Eigenschaften (T(Sp)) eines zu simulierenden Detektors zu modifizieren.

8. System nach einem der Ansprüche 1 bis 7, wobei die Vorrichtung eine Mehrzahl von Pulsgeneratoren (G1, GN) umfasst, wobei jeder mit einem Empfänger (R1, RN) von Signalen gekoppelt ist, die durch den wenigstens einen Sender (E1, E2, EM) gesendet werden.

9. System nach einem der Ansprüche 1 bis 8, weiterhin umfassend ein Auswahlmodul (S1, SN) das dazu konfiguriert ist, selektiv die Verarbeitungselektronik (T) mit einem Detektor (D1, DN) für eine oder mehrere radioaktive Quellen im nominellen Detektionsbetrieb zu koppeln, oder mit dem Pulsgenerator (G1, GN) in einer Testphase der Verarbeitungselektronik.

10. System nach Anspruch 9, weiterhin umfassend einen oder mehrere mobile Sender von Signalen.

11. Verfahren zur Simulation der Detektion wenigstens einer mobilen radioaktiven Quelle, umfassend das Senden von Signalen durch wenigstens einen Sender (E) und das Empfangen von Signalen durch einen Empfänger (R1, RN), **dadurch gekennzeichnet, dass** es die folgenden Schritte umfasst, die durch einen Pulsgenerator (G1, GN, GV1, GV2) durchgeführt werden, der einerseits mit dem Empfänger (R1, RN) und andererseits mit einer zu testenden Verarbeitungselektronik (T) gekoppelt ist, die dazu bestimmt ist, im nominellen Detektionsbetrieb mit einem oder mehreren Detektoren (D1, DN) für eine oder mehrere radioaktive Quellen gekoppelt zu sein, bestehend aus:
• Bestimmen eines Abstands (deltal) zwischen dem Empfänger (R1, RN), und dem wenigstens einem Sender (E), ausgehend von einem Signal, das von dem wenigstens einen Sender durch den Empfänger empfangen wird,
• Erzeugen von Pulsen, deren Anzahl (FeP) als Funktion des detektierten Abstands variiert, und
• Liefern der erzeugten Pulse zu der zu testenden Verarbeitungselektronik (T).

12. Computerprogrammprodukt, umfassend Code-Anweisungen zur Durchführung der Schritte des Verfahrens nach Anspruch 11, die durch den Pulsgenerator (G1, GN, GV1, GV2) durchgeführt werden, wenn das Programm auf einem Computer ausgeführt wird.

## Claims

1. System simulating the detection of at least one moving radioactive source, including a at least one signals transmitter (E1, E2, EM), a device simulating the detection of the at least one moving radioactive source receiver, and an electronic processing unit (T) to be tested, intended to be coupled, in nominal detection usage, to one or more detectors (D1, DN) of one or more radioactive sources, said device comprising:
- a receiver (R1, RN) for receiving signals transmitted by the at least one signal transmitter (E1, E2, EM); and
- a pulse generator (G1, GN, GV1, GV2) coupled to the receiver (R1, RN) and configured to determine a distance (Deltal) between the receiver (R1, RN) and the at least one transmitter (E1, E2, EM) from a signal received from the at least one transmitter by the receiver, to generate pulses of which the number (FeP) varies as a function of the detected distance, and to deliver the generated pulses to the electronic processing unit (T) to be tested.

2. System according to claim 1, in which the pulse generator is configured to periodically determine a number of pulses to generate as a function of the determined distance, and to generate randomly said number of determined pulses during the period following said determination.

3. System according to one of claims 1 and 2, in which the pulse generator is further configured to generate pulses of which the shape is characteristic of one or more radioactive sources.

4. System according to claim 3, in which the shape of the pulses to generate includes an amplitude, a rise time and a fall time of the pulses.

5. System according to claim 4, in which the amplitude of the pulses is determined by the pulse generator from an energy spectrum (Sp) representing a probability of appearance of pulses as a function of the amplitude.

6. System according to claim 5, in which the pulse generator is configured to extract the energy spectrum from the signal received from the transmitter by the receiver.

7. System according to one of claims 5 and 6, in which the pulse generator is configured to modify the energy spectrum as a function of characteristics (T(Sp)) of a detector to simulate.

8. System according to one of claims 1 to 7, in which said device includes a plurality of pulse generators (G1, GN), each coupled to a receiver (R1, RN) of the signals transmitted by the at least one transmitter (E1, E2, EM).

9. System according to claim 8, further including a selection module (S1, SN) configured to make it possible to couple selectively the electronic processing unit (T) to a detector (D1, DN) of one or more radioactive sources in nominal detection usage, or to the pulse generator (G1, GN) in test phase of the electronic processing unit.

10. System according to claim 9, further including one or more moving signal transmitters.

11. Simulation method for detecting at least one moving radioactive source, including the transmission of signals by at least one transmitter (E) and the receiving of signals by a receiver (R1, RN), **characterised in that** it comprises the following steps implemented by a pulse generator (G1, GN, GV1, GV2) coupled, on the one hand, to the receiver (R1, RN), and, on the other hand, to an electronic processing unit (T) to be tested, intended to be coupled, in nominal detection usage, to one or more detectors (D1, DN) of one or more radioactive sources, consisting in:
- determining a distance (deltal) between the receiver (R1, RN) and the at least one transmitter (E) from a signal received from the at least one transmitter by the receiver;
- generating pulses of which the number (FeP) varies as a function of the distance detected; and
- deliver the generated pulses to the electronic processing unit (T) to be tested.

12. Computer program product, including code instructions for the execution of the steps of the method according to claim 11 implemented by the pulse generator (G1, GN, GV1, GV2), when said programme is executed on a computer.
